# EUROPEAN PATENT SPECIFICATION

(11) **EP 2 041 742 B1**
(45) Date of publication and mention of the grant of the patent: **20.03.2013**
(21) Application number: 07768595.6
(22) Date of filing: 04.07.2007
(51) Int. Cl.: G10L 19/00, G10L 19/02

(54) **APPARATUS AND METHOD FOR RESTORING MULTI-CHANNEL AUDIO SIGNAL USING HE-AAC DECODER AND MPEG SURROUND DECODER**
VORRICHTUNG UND VERFAHREN ZUM WIEDERHERSTELLEN EINES MEHRKANALIGEN AUDIOSIGNALS UNTER VERWENDUNG EINES HE-AAC-DECODERS UND EINES MPEG-SURROUND-DECODERS
APPAREIL ET PROCEDE DE RESTITUTION DE SIGNAL AUDIO MULTIVOIE METTANT EN OEUVRE UN DECODEUR HE-AAC ET UN DECODEUR STEREOPHONIQUE MPEG

(30) Priority: 04.07.2006 KR 20060062609; 13.07.2006 KR 20060065948
(43) Date of publication of application: 01.04.2009
(60) Divisional application: 11184461.9
(73) Proprietor: Electronics and Telecommunications Research Institute, Yuseong-gu Daejon 305-350 (KR)
(72) Inventor: SEO, Jeong-Il, Daejon 305-728 (KR); BEACK, Seung-Kwon, Daejon 305-348 (KR); JANG, In-Seon, Gyeonggi-do 435-040 (KR); JANG, Dae-Young, Daejon 305-768 (KR); KIM, Jin-Woong, Daejon 305-761 (KR); HONG, Jin-Woo, Yuseong-gu Daejon 305-333 (KR)
(74) Representative: Betten & Resch
(86) International application number: PCT/KR2007/003247
(87) International publication number: WO 2008/004812

(56) References cited:
- PURNHAGEN H.: 'Low Complexity Parametric Stereo Coding In MPEG-4' PROC. OF THE 7TH INT. CONFERENCE ON DIGITAL AUDIO EFFECTS (DAFX'04), NAPELS, ITALY 05 October 2004, XP002364489
- HERRE J. ET AL.: 'The Reference Model Architecture for MPEG Spatial Audio Coding' PROC. 118TH AES CONVENTION May 2005, XP009059973
- WOLTERS M. ET AL.: 'A closer look into MPEG-4 High Efficiency AAC' PROC. 115TH AES CONVENTION 10 October 2003, XP008063876

## Description

### TECHNICAL FIELD

The present invention relates to an apparatus and method for synchronizing downmix signals with Moving Picture Experts Group (MPEG) surround side information signals at an MPEG surround decoder by accounting for delay according to the kind of a downmix audio signal. Particularly, the present invention relates to an apparatus and method for maintaining the synchronization of multi-channel audio signals outputted from an MPEG. surround decoder by accounting for different delays between downmix signals of the time domain and downmix signals of the Quadrature Mirror Filter (QMF) domain signals, when the MPEG surround decoder is linked with the HE-AAC decoder.

### BACKGROUND ART

Moving Picture Experts Group (MPEG) surround technology compresses multi-channel audio signals into downmix signals and side information. The MPEG surround technology can implement a decoder for the downmix signals and the side information bitstream transmitted from an encoder in either high-quality mode or low-power mode. A high-quality MPEG surround decoder provides high audio quality by using a residual signal and a temporal processing (TP) tool, but it requires a high degree of complexity. On the contrary, a low-power MPEG surround decoder reduces the complexity in such a method as changing computation of a Quadrature Mirror Filter (QMF) into a real number computation. Although the audio quality is somewhat degraded, the low-power MPEG surround decoder is appropriate for terminals consuming low power such as mobile phones.

An MPEG surround decoder restores downmix signals compressed with a general mono/stereo audio encoder, e.g., an Advanced Audio Coded (AAC) encoder or a High-Efficiency Advanced Audio Coding (HE-AAC) encoder, into multi-channel audio signals by using side information bitstream. Since the side information bitstream used herein is provided for each frequency band, the downmix signals should be converted to frequency bands using a hybrid filter bank, which consists of a QMF bank and a Nyquist filter bank. This conversion causes a delay. When the downmix signals are acquired after QMF processing of the HE-AAC decoder, as in the MPEG surround decoder, signals of the QMF domain can be directly extracted and applied to the MPEG surround decoder to thereby prevent delay caused by filtering.

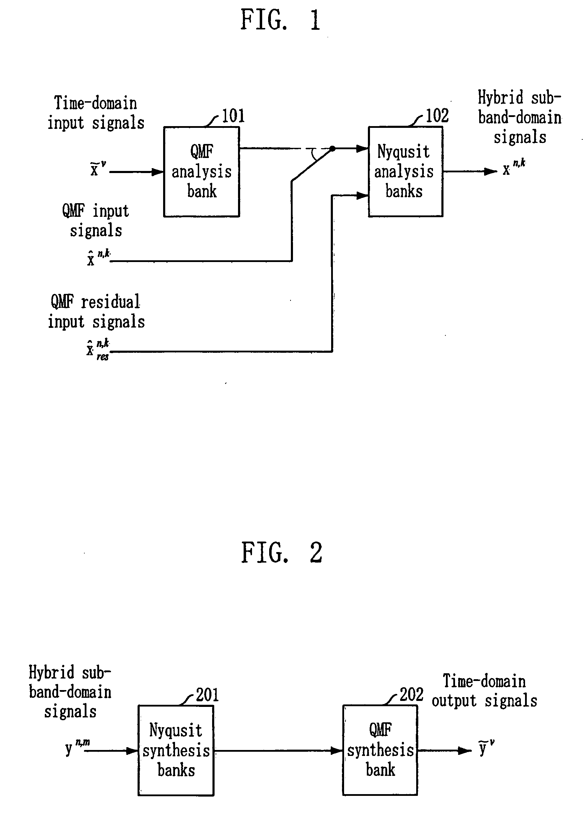

The high-quality MPEG surround decoder can use not only the downmix signals of the time domain but also the downmix signals of the QMF domain that are acquired from the HE-AAC decoding process, as shown in Fig. 1. When the downmix signals of the time domain are used, a delay corresponding to 704 samples occurs in the process of executing a QMF analysis filter bank 101 and a Nyquist analysis filter bank 102. Also, a delay corresponding to 0 sample occurs in a Nyquist synthesis filter bank 201 and a delay corresponding to 257 samples occurs in the QMF synthesis filter bank 202 in the synthesis process of multi-channel audio signals shown in Fig. 2. In total, a delay corresponding to 961 samples occurs. When downmix signals encoded with an HE-AAC encoder are used, signals of the QMF domain that can be acquired from the HE-AAC decoding process can be directly used because the QMF of the high-quality MPEG surround decoder and the QMF of the HE-AAC decoder are identical. Also, since look-ahead signals corresponding to 384 samples needed for Nyquist banks is already available in a Spectral Band Replication (SBR) tool of the HE-AAC decoder, there is an advantage that no delay occurs in the filtering process.

However, when the downmix signals encoded with the HE-AAC encoder are applied to the MPEG surround decoder in the time domain, spatial parameters extracted from MPEG surround side information signals are delayed by 961 samples, including the delay corresponding to 257 samples occurring in the QMF synthesis process of the HE-AAC decoder and the delay corresponding to 704 samples occurring in the QMF filtering and the Nyquist filtering processes of the high-quality MPEG surround decoder. Thus, the downmix signals are synchronized between the HE-AAC decoder and the high-quality MPEG surround decoder to thereby be restored to desired multi-channel signals.

References, "ISO/IEC JTC1/SC29/MG11 N8177, Study on Text of ISO/IEC FCD 23003-1, MPEG Surround", "Audio Engineering Society Convention Paper presented at the 115th Convention, October 10 through 13, 2003, New York", and "Audio Engineering Society Convention Paper presented at the 119th Convention, October 7 through 10, 2005, New York" are made.

Herre et al.: "The Reference Model Architecture for MPEG Spatial Audio coding", AES CONVENTION PAPER, NEW YORK, NY, US, 28 May 2005 (2005-05-28), XP009059973 describes the technical architecture and capabilities of the MPEG Spatial Audio Coding Reference Model 0 architecture, which results from a combination of the strongest features of the two systems found best during the MPEG CfP evaluation process. This architecture provides a wide range of scalability, which helps to cover almost any conceivable application scenario.

### DISCLOSURE

### TECHNICAL PROBLEM

An embodiment of the present invention is directed to providing an apparatus and method for maintaining the synchronization of multi-channel audio signals outputted from an MPEG surround decoder by accounting for different delays between downmix signals of the time domain and downmix signals of the Quadrature Mirror Filter (QMF) domain signals, when the MPEG surround decoder is linked with the HE-AAC decoder.

### TECHNICAL SOLUTION

In accordance with an aspect of the present invention, there are provided a MPEG surround decoder and a method for restoring multi-channel audio signals as claimed in claims 1 and 6, respectively.

### ADVANTAGEOUS EFFECTS

As described above, the technology of the present invention can restore desired multi-channel audio signals by sustaining synchronization between downmix signals and MPEG surround side information signals by adding a delay unit when the downmix signals outputted from the HE-AAC decoder are applied to the MPEG surround decoder in format of either signals of the real QMF domain or signals of the complex QMF domain.

### BRIEF DESCRIPTION OF THE DRAWINGS

Fig. 1 is a block view showing a hybrid analysis filter bank of a high-quality Moving Picture Experts Group (MPEG) surround decoder;
Fig. 2 is a block view showing a hybrid synthesis filter bank of the high-quality MPEG surround decoder;
Fig. 3 illustrates a process for synthesizing multi-channel audio signals using an HE-AAC decoder and a low-power MPEG surround decoder;
Fig. 4 is a block view showing a hybrid analysis filter bank and a hybrid synthesis filter bank of the low-power MPEG surround decoder;
Fig. 5 is a block view describing a hybrid analysis filter bank and a hybrid synthesis filter bank of a low-power MPEG surround decoder including a delay unit according to the present invention; and
Fig. 6 is a block view illustrating a hybrid analysis filter bank and a hybrid synthesis filter bank of a high-quality MPEG surround decoder including a delay unit according to the present invention.

### BEST MODE FOR THE INVENTION

Embodiments of the invention will be described in detail with reference to the accompanying drawings.

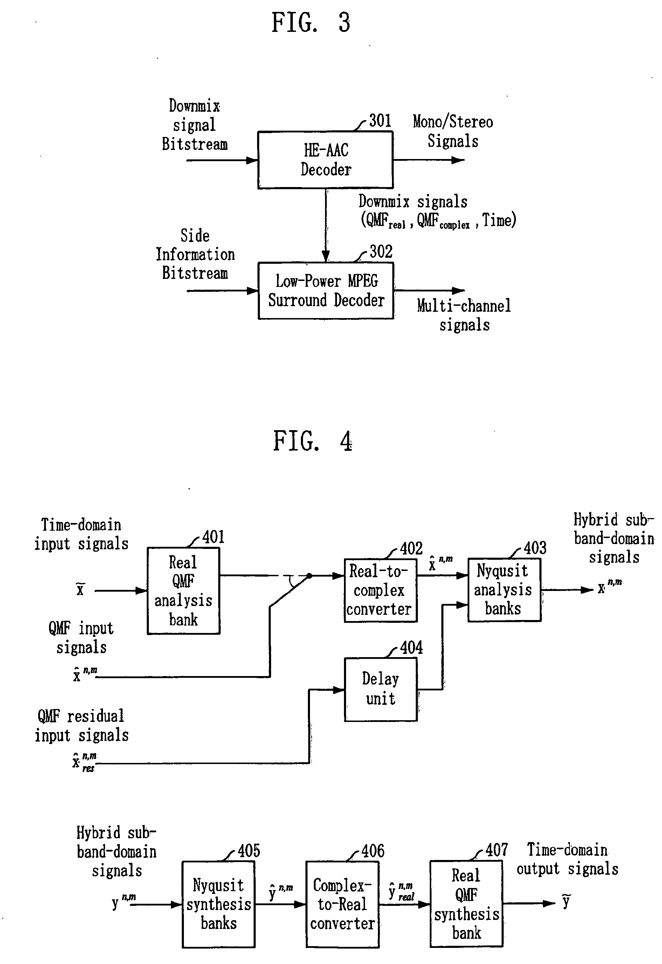

First, Fig. 3 illustrates a process for synthesizing multi-channel audio signals using a HE-AAC decoder and a low-power MPEG surround decoder.

A HE-AAC decoder 301 receives downmix signal bitstream and outputs mono/stereo signals and downmix signals. The downmix signals outputted from the HE-AAC decoder 301 are inputted into a low-power MPEG surround decoder 302 along with side information bitstream, and the low-power MPEG surround decoder 302 restores and outputs multi-channel audio signals.

When the downmix signals are encoded in an HE-AAC encoder and side information is extracted from the multi-channel audio signals in an MPEG surround encoder, the downmix signals are decoded through the HE-AAC decoder 301, and the multi-channel audio signals are restored through the low-power MPEG surround decoder 302. Herein, the QMF coefficients of the downmix signals extracted from the HE-AAC decoder 301 are real numbers in case of a low-complexity HE-AAC decoder 301, or they are complex numbers in case of a general HE-AAC decoder. Also, downmix signals of the time domain may be extracted from the HE-AAC decoder 301 and used.

Fig. 4 is a block view showing a hybrid analysis filter bank and a hybrid synthesis filter bank of the low-power MPEG surround decoder.

As shown in the drawing, when downmix signals of the time domain are inputted to the low-power MPEG surround decoder, time delay occurs in a real QMF analysis filter bank 401, a real QMF synthesis filter bank 407, a Nyquist analysis filter bank 403, a Nyquist synthesis filter bank 405, a real-to-complex converter 402, and a complex-to-real converter 406. However, when downmix signals of a real QMF domain outputted from the low-complexity HE-AAC decoder are used, delay occurs only in the real-to-complex converter 402 and the complex-to-real converter 406. The delay caused in the real QMF analysis filter bank 401 and the real QMF synthesis filter bank 407 is already taken into consideration because an SBR tool of the HE-AAC decoder uses an identical QMF filter. Also, since look-ahead information needed for the Nyquist analysis filter bank 403 and the Nyquist synthesis filter bank 405 is available in the SBR tool, additional delay is not needed. In addition, a delay unit 404 for QMF residual signals accounts for the delay introduced by the real-to-complex converter 402 to thereby synchronize signals inputted into the Nyquist analysis filter bank 403.

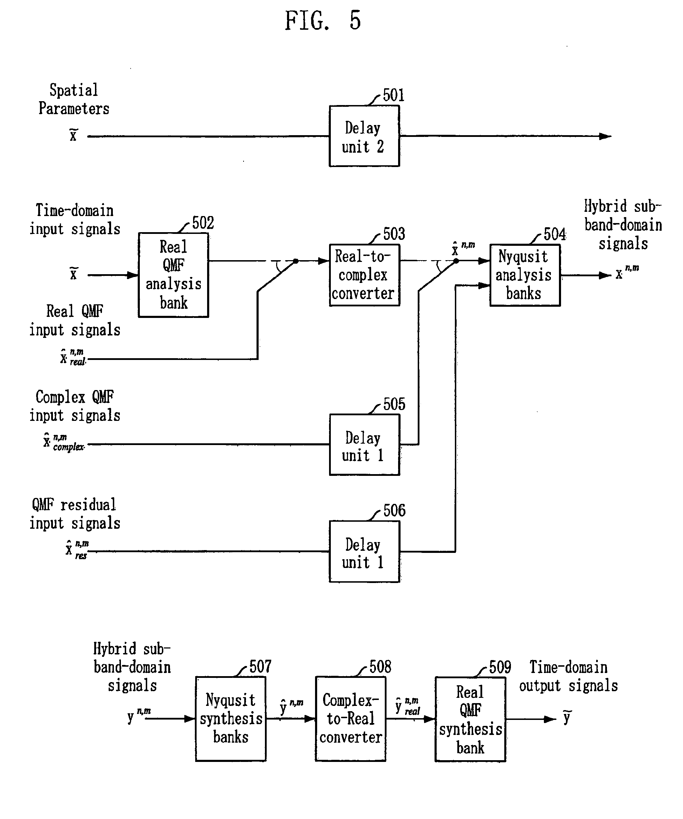

The present invention provides a method for synchronizing downmix signals of the real QMF domain, downmix signals of the complex QMF domain and downmix signal of the time-domain with output signals of the low-power MPEG surround decoder (i.g., spatial parameters). The process is described with reference to Fig. 5.

Fig. 5 is a block view describing a hybrid analysis filter bank and a hybrid synthesis filter bank of a low-power MPEG surround decoder including a delay unit according to the present invention.

When complex QMF signals extracted right ahead of the QMF synthesis filter bank of a general HE-AAC decoder are inputted to a hybrid filter of the low-power MPEG surround decoder, the complex QMF signals does not have to pass through the real-to-complex converter 503. Thus, the downmix signals of the complex QMF domain are directly inputted to the Nyquist analysis filter bank 504. Herein, a delay unit 505 is additionally needed to account for the delay introduced as downmix signals of the time domain or the real QMF domain pass through the real-to-complex converter 503. Just as the downmix signals of the real QMF domain are used, the delays caused by a real QMF analysis filter bank 502, a real QMF synthesis filter bank 509, Nyquist analysis filter banks 504, and Nyquist synthesis filter banks 507 is taken into consideration in the HE-AAC decoder. Thus, there is no additional delay caused by them.

When the time-domain downmix signals decoded at the HE-AAC decoder are provided to the low-power MPEG surround decoder, a delay unit 501 is added to apply delay corresponding to the sum of samples corresponding to the delay caused in the HE-AAC QMF synthesis filter bank, samples corresponding to the delay caused in the real QMF analysis filter bank 502, samples corresponding to the delay caused in the Nyquist analysis filter banks 504, and samples corresponding to the delay caused in the real-to-complex converter 503, to the spatial parameters extracted from MPEG surround side information signals to thereby synchronizing the HE-AAC decoder and the low-power MPEG surround decoder for downmix signals.

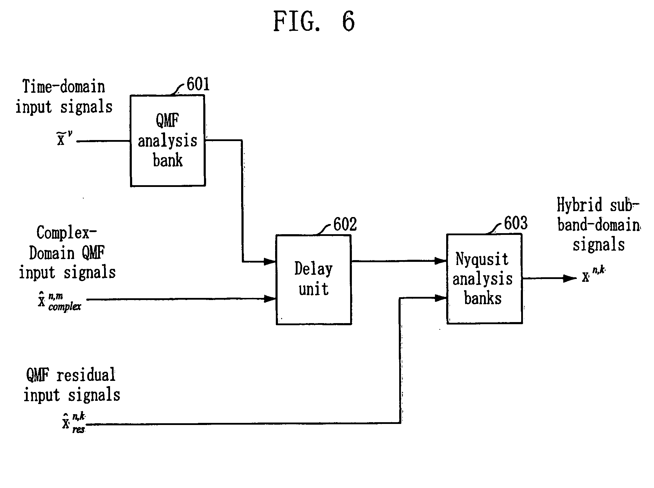

Fig. 6 is a block view illustrating a hybrid analysis filter bank and a hybrid synthesis filter bank of a high-quality MPEG surround decoder including a delay unit according to the present invention. Referring to the drawing, downmix signals of the time domain are inputted to a delay unit 602 through a QMF analysis filter bank 601, and downmix signals of the complex QMF domain are directly inputted to the delay unit 602. The output of the delay unit 602 is inputted to Nyquist analysis filter bank 603 along with QMF residual input signals, and the Nyquist analysis filter bank 603 outputs hybrid sub-band signals.

As the delay unit 505 is added when an HE-AAC decoder is linked with a low-power MPEG surround decoder, a delay unit 602 is added for the complex QMF signals. The delay unit 602 is added for the complex QMF signals to synchronize a high-quality MPEG surround decoder by accounting for the delay caused in the real-to-complex converter 503 of the low-power MPEG surround decoder.

### MODE FOR INVENTION

While the present invention has been described with respect to the specific embodiments, it will be apparent to those skilled in the art that various changes and modifications may be made without departing from the scope of the invention as defined in the following claims.

### INDUSTRIAL APPLICABILITY

The present invention may be applied to synchronize downmix signals with spatial parameters, when high-quality multi-channel audio signals are restored while maintaining compatibility with conventional mono/stereo audio receivers.

## Claims

1. A Moving Picture Experts Group (MPEG) surround decoder for restoring multi-channel audio signals based on downmix signals and side information bitstream that are inputted from a High-Efficiency Advanced Audio Coding (HE-AAC) decoder (301), comprising:
a real-to-complex converter (402, 503) for converting real Quadrature Mirror Filter (QMF) signals outputted from the HE-AAC decoder (301) into complex QMF signals; and
a first delay unit (404, 506) for applying a delay caused in the real-to-complex converter (402, 503) to QMF residual input signals outputted from the HE-AAC decoder in order to synchronize the QMF residual input signals with the complex QMF signals outputted by the real-to-complex converter (402, 503).

2. The MPEG surround decoder of claim 1, further comprising:
a second delay unit (501) for applying a delay caused in QMF banks (502) and Nyquist banks (504) to spatial parameters of time-domain downmix signals outputted from the HE-AAC decoder.

3. An apparatus for restoring multi-channel audio signals comprising a HE-AAC decoder (301) and a MPEG surround decoder (302) as defined in claim 1 or 2.

4. The MPEG surround decoder of claim 1, wherein the downmix signals are at least one among a real QMF domain, a complex QMF domain, and a time domain, further comprising:
a QMF analyzing unit (401, 502) for performing real QMF analysis onto downmix signals of the time domain; and
a delay unit (505) for applying delay introduced in the real-to-complex conversion to downmix signals of the complex QMF domain.

5. An apparatus for restoring multi-channel audio signals, comprising:
an HE-AAC decoder (301) for decoding downmix signal bitstream and outputting downmix signals of at least one among a real QMF domain, a complex QMF domain, and time domain; and
an MPEG surround decoder (302) as defined in claim 4.

6. A method for restoring multi-channel audio signals based on downmix signals and side information bitstream that are inputted from an HE-AAC decoder (301), comprising the steps of:
generating multi-channel audio signals based on side information bitstream and the downmix signals,
wherein the step of generating multi-channel audio signals includes the steps of:
converting real QMF signals outputted from the HE-AAC decoder (301) into complex QMF signals; and
applying a delay caused in the real-to-complex conversion step to QMF residual input signals in order to synchronize the QMF residual input signals with the complex QMF signals.

7. The method of claim 6, further comprising the step of:
applying a delay caused in QMF banks (502) and Nyquist banks (504) to spatial parameters of time-domain downmix signals outputted from the HE-AAC decoder (301).

8. The method of claim 7, further comprising the step of:
outputting downmix signals of at least one among a real QMF domain, a complex QMF domain, and time domain by decoding downmix signal bitstream;
wherein the step of generating multi-channel audio signals further includes the steps of:
performing real QMF analysis onto downmix signals of the time domain; and applying delay introduced in the real-to-complex conversion to downmix signals of the complex QMF domain.

## Patentansprüche

1. Moving Picture Experts Group (MPEG)-Surround-Dekodierer zum Wiederherstellen von mehrkanaligen Audiosignalen basierend auf Downmix-Signalen und einem Seiteninformationsbitstrom, welche von einem High Efficiency-Advanced Audio Coding (HE-AAC)-Dekodierer (301) eingegeben sind, umfassend:
einen Real-zu-Komplex-Konvertierer (402, 503) zum Konvertieren von Real-Quadrature Mirror Filter (QMF)-Signalen, die von dem HE-AAC-Dekodierer (301) ausgegeben sind, in Komplex-QMF-Signale; und
eine erste Verzögerungseinheit (404, 506) zum Anwenden einer Verzögerung, die in dem Real-zu-Komplex-Konvertierer (402, 503) verursacht wurde, auf QMF-Rest-Eingangssignale, die von dem HE-AAC-Dekodierer ausgegeben sind, um die QMF-Rest-Eingangssignale mit den Komplex-QMF-Signalen, die von dem Real-zu-Komplex-Konvertierer (402, 503) ausgegeben sind, zu synchronisieren.

2. MPEG-Surround- Dekodierer nach Anspruch 1, ferner umfassend:
eine zweite Verzögerungseinheit (501) zum Anwenden einer Verzögerung, die in QMF-Banken (502) und Nyquist-Banken (504) verursacht wurde, auf Raumparameter der Downmix-Signale der Zeitdomain, die von dem HE-AAC-Dekodierer ausgegeben sind.

3. Vorrichtung zum Wiederherstellen von mehrkanaligen Audiosignalen, umfassend einen HE-AAC- Dekodierer (301) und einen MPEG-Surround-Dekodierer (302) nach Anspruch 1 oder 2.

4. MPEG-Surround- Dekodierer nach Anspruch 1, wobei die Downmix-Signale von einer Real-QMF-Domain, einer Komplex-QMF-Domain und/oder einer Zeitdomain sind, ferner umfassend:
eine QMF-Analyse-Einheit (401, 502) zum Durchführen einer Real-QMF-Analyse auf Downmix-Signalen der Zeitdomain; und
eine Verzögerungseinheit (505) zum Anwenden einer Verzögerung, die in der Real-zu-Komplex-Konvertierung eingeführt wurde, auf die Downmix-Signale der Komplex-QMF-Domain.

5. Vorrichtung zum Wiederherstellen von mehrkanaligen Audiosignalen, umfassend:
einen HE-AAC-Dekodierer (301) zum Dekodieren eines Downmix-Signal-Bitstromes und Ausgeben von Downmix-Signalen von einer Real-QMF-Domain, einer Komplex-QMF-Domain und/oder einer Zeitdomain; und
einen MPEG-Surround- Dekodierer (302) nach Anspruch 4.

6. Verfahren zum Wiederherstellen von mehrkanaligen Audiosignalen basierend auf Downmix-Signalen und einem Seiteninformationsbitstrom, die von einem HE-AAC- Dekodierer (301) eingegeben werden, umfassend die Schritte:
Erzeugen von mehrkanaligen Audiosignalen basierend auf dem Seiteninformationsbitstrom und den Downmix-Signalen,
wobei der Schritt des Erzeugens von mehrkanaligen Audiosignalen die Schritte enthält:
Konvertieren von Real-QMF-Signalen, die von dem HE-AAC- Dekodierer (301) ausgegeben werden, in Komplex-QMF-Signale; und
Anwenden einer Verzögerung, die in dem Real-zu-Komplex-Konvertierungsschritt verursacht wurde, auf QMF-Rest-Eingangssignale, um die QMF-Rest-Eingangssignale mit den Komplex-QMF-Signalen zu synchronisieren.

7. Verfahren nach Anspruch 6, ferner umfassend den Schritt:
Anwenden einer Verzögerung, die in QMF-Banken (502) und Nyquist-Banken (504) verursacht wurde, auf Raumparameter von Downmix-Signalen der Zeitdomain, die von dem HE-AAC- Dekodierer (301) ausgegeben werden.

8. Verfahren nach Anspruch 7, ferner umfassend den Schritt:
Ausgeben von Downmix-Signalen einer Real-QMF-Domain, einer Komplex-QMF-Domain und/oder einer Zeitdomain durch Dekodieren eines Downmix-Signal-Bitstromes;
wobei der Schritt des Erzeugens von mehrkanaligen Audiosignalen ferner die Schritte enthält:
Durchführen einer Real-QMF-Analyse auf Downmix-Signalen der Zeitdomain; und Anwenden einer Verzögerung, die in der Real-zu-Komplex-Konvertierung eingeführt wurde, auf Downmix-Signale der Komplex-QMF-Domain.

## Revendications

1. Décodeur d'ambiance MPEG (MPEG pour Groupe d'experts d'images animées) pour restaurer des signaux audio multicanaux en se basant sur des signaux de mixage réducteur et un train de bits d'informations annexes qui sont entrés par un décodeur HE-AAC (HE-AAC pour Codage audio avancé haute efficacité) (301), comprenant :
un convertisseur réel-à-complexe (402, 503) pour convertir des signaux de filtre miroir en quadrature (QMF) réels produits en sortie par le décodeur HE-AAC (301) en signaux QMF complexes ; et
une première unité à retard (404, 506) pour appliquer un retard provoqué dans le convertisseur réel-à-complexe (402, 503) à des signaux d'entrée résiduels QMF produits en sortie par le décodeur HE-AAC afin de synchroniser les signaux d'entrée résiduels QMF avec les signaux QMF complexes produits en sortie par le convertisseur réel-à-complexe (402, 503).

2. Décodeur d'ambiance MPEG selon la revendication 1, comprenant en outre :
une seconde unité à retard (501) pour appliquer un retard provoqué dans des banques QMF (502) et des banques Nyquist (504) à des paramètres spatiaux de signaux de mixage réducteur de domaine temporel produits en sortie par le décodeur HE-AAC.

3. Appareil de restauration de signaux audio multicanaux comprenant un décodeur HE-AAC (301) et un décodeur d'ambiance MPEG (302) tels que définis dans la revendication 1 ou 2.

4. Décodeur d'ambiance MPEG selon la revendication 1, dans lequel des signaux de mixage réducteur sont au moins l'un parmi un domaine QMF réel, un domaine QMF complexe et un domaine temporel, comprenant en outre :
une unité d'analyse QMF (401, 502) pour réaliser une analyse QMF réelle sur des signaux de mixage réducteur du domaine temporel ; et
une unité à retard (505) pour appliquer un retard introduit dans la conversion réel-à-complexe à des signaux de mixage réducteur du domaine QMF complexe.

5. Appareil de restauration de signaux audio multicanaux, comprenant :
un décodeur HE-AAC (301) pour décoder un train de bits de signal de mixage réducteur et produire en sortie des signaux de mixage réducteur d'au moins l'un parmi un domaine QMF réel, un domaine QMF complexe et un domaine temporel ; et
un décodeur d'ambiance MPEG (302) tel que défini à la revendication 4.

6. Procédé de restauration de signaux audio multicanaux basé sur des signaux de mixage réducteur et un train de bits d'informations annexes qui sont entrés par un décodeur HE-AAC (301), comprenant les étapes :
de génération de signaux audio multicanaux basée sur un train de bits d'informations annexes et les signaux de message réducteur,
dans lequel l'étape de génération de signaux audio multicanaux comprend les étapes :
de conversion de signaux QMF réels produits en sortie par le décodeur HE-AAC (301) en signaux QMF complexes ; et
d'application d'un retard provoqué à l'étape de conversion réel-à-complexe à des signaux d'entrée résiduels QMF afin de synchroniser les signaux d'entrée résiduels QMF avec les signaux QMF complexes.

7. Procédé selon la revendication 6, comprenant en outre l'étape :
d'application d'un retard provoqué dans des banques QMF (502) et des banques Nyquist (504) à des paramètres spatiaux de signaux de mixage réducteur de domaine temporel produits en sortie par le décodeur HE-AAC (301).

8. Procédé selon la revendication 7, comprenant en outre l'étape :
de production en sortie de signaux de mixage réducteur d'au moins l'un parmi un domaine QMF réel, un domaine QMF complexe et un domaine temporel, en décodant un train de bits de signaux de mixage réducteur ;
dans lequel l'étape de génération de signaux audio multicanaux comprend en outre les étapes :
de réalisation d'une analyse QMF réelle sur des signaux de mixage réducteur du domaine temporel ; et d'application d'un retard introduit dans la conversion réel-à-complexe à des signaux de mixage réducteur du domaine QMF complexe.
